# EUROPEAN PATENT SPECIFICATION

(11) **EP 4 486 082 B1**
(45) Date of publication and mention of the grant of the patent: **07.10.2026**
(21) Application number: 23849013.0
(22) Date of filing: 26.05.2023
(51) Int. Cl.: G06F 1/187, H05K 7/20, G06F 1/20

(54) **HEAT DISSIPATION DEVICE AND ELECTRONIC APPARATUS**
WÄRMEABLEITUNGSVORRICHTUNG UND ELEKTRONISCHE VORRICHTUNG
DISPOSITIF DE DISSIPATION DE CHALEUR ET APPAREIL ÉLECTRONIQUE

(30) Priority: 30.07.2022 CN 202210912579
(43) Date of publication of application: 01.01.2025
(73) Proprietor: xFusion Digital Technologies Co., Ltd., Zhengzhou, Henan 450000 (CN)
(72) Inventor: JIA, Hui, Zhengzhou, Henan 450000 (CN); WANG, Chenglong, Zhengzhou, Henan 450000 (CN)
(74) Representative: MERH-IP Matias Erny Reichl Hoffmann Patentanwälte PartG mbB
(86) International application number: PCT/CN2023/096646
(87) International publication number: WO 2024/027303

(56) References cited:
- WO-A1-2016/026271
- CN-A- 107 146 924
- CN-A- 114 115 470
- CN-U- 209 358 905
- CN-U- 214 410 780
- CN-U- 215 600 094
- CN-U- 216 697 261
- CN-U- 216 697 262
- CN-U- 217 086 135
- US-A1- 2012 103 571

## Description

### TECHNICAL FIELD

This application relates to the field of heat dissipation technologies, and in particular, to a heat dissipation apparatus and an electronic device.

### BACKGROUND

In the context of China's Carbon Peaking and Carbon Neutrality Goals, energy efficiency improvement in data centers has become a hot topic today. In an existing electronic device, there are usually a large quantity of hard disks and total power is large, which causes severe heat generation in the hard disks. However, efficiency of heat conduction between an existing heat dissipation apparatus and a hard disk is relatively low, and heat dissipation performance is poor.

US20120103571A1 provides a structure of heat dissipation of an electronic device includes at least one heat pipe and a cooler. The heat pipe has a condensation end and an evaporation end opposite to each other, and the evaporation end is disposed on a heat generating element of the electronic device. The cooler is disposed on a rack and has a chamber therein, and the chamber has an inner shell having a cooling fluid therein. When the electronic device is mounted in the rack, the condensation end of the heat pipe is inserted into the cooler and positioned into the inner shell.

WO2016026271A1 provides a heat dissipation apparatus for a hard disk array.

### SUMMARY

This application provides a heat dissipation apparatus and an electronic device, to improve efficiency of heat conduction between the heat dissipation apparatus and hard disks, and improve heat dissipation performance.

According to a first aspect, this application provides a heat dissipation apparatus, including a heat sink and a plurality of heat conduction components. The plurality of heat conduction components are all connected to the heat sink, and the plurality of heat conduction components are arranged at intervals. One plug interface is formed between two adjacent heat conduction components, and the plug interface is used for one hard disk to be plugged in.

In the heat dissipation apparatus shown in this application, heat generated when a hard disk works may be first transferred to two adjacent heat conduction components, and then transferred to the heat sink through the two adjacent heat conduction components, thereby effectively improving efficiency of heat conduction between the heat sink and the hard disk, improving heat dissipation performance of the heat sink for the hard disk, and implementing effective heat dissipation for the hard disk. When the heat dissipation apparatus is used in an electronic device, the electronic device can support deployment of high-density hard disks, and can further implement heat dissipation for the high-power hard disks.

The hard disk includes a first contact surface and a second contact surface that are disposed opposite to each other, and the first contact surface and the second contact surface are respectively in contact with two adjacent heat conduction components, to increase a contact area between the hard disk and the heat conduction components, improve efficiency of heat transfer between the hard disk and the heat conduction components, and improve heat dissipation performance of the heat dissipation apparatus for the hard disk.

In a possible implementation, both the first contact surface and the second contact surface are parallel to an extension direction of the hard disk, to ensure that a surface with a largest area of the hard disk is in contact with the heat conduction component, increase a contact area between the hard disk and the heat conduction component, improve efficiency of heat transfer between the hard disk and the heat conduction component, and improve heat dissipation performance of the heat dissipation apparatus for the hard disk.

The heat conduction component includes a body and at least one heat conduction member, and a material of the body is a heat conducting material. The body includes a third contact surface and a fourth contact surface that are disposed opposite to each other, the heat conduction member is located on at least one of the third contact surface and the fourth contact surface, and the heat conduction member is connected to the heat sink.

Heat generated when the hard disk works may be transferred to the heat conduction member, or may be transferred to the heat conduction member through the body, and then transferred to the heat sink through the heat conduction member, so as to effectively dissipate heat from the hard disk.

In a possible implementation, the heat conduction member is a heat pipe, to improve efficiency of heat transfer between the hard disk and the heat conduction member, and further improve efficiency of heat transfer between the hard disk and the heat conduction component.

In a possible implementation, the heat conduction component further includes at least one contact member, and the contact member is located on at least one of the third contact surface and the fourth contact surface.

When the heat conduction member exists on a contact surface on which the contact member is located, the contact member is located on a side that is of the heat conduction member and that is away from the body, and is in contact with the heat conduction member.

Alternatively, when the heat conduction member does not exist on the contact surface on which the contact member is located, the contact member is directly in contact with the body.

Heat generated when the hard disk works may be transferred to the contact part, and then transferred to the heat conduction member through the contact member, or transferred to the heat conduction member through the contact member and the body, and finally transferred to the heat sink through the heat conduction member, thereby effectively dissipating heat from the hard disk.

Alternatively, the heat conduction component includes a body and at least one heat conduction member, and a material of the body is not a heat conducting material. The body includes a third contact surface and a fourth contact surface that are disposed opposite to each other, the heat conduction member is located on at least one of the third contact surface and the fourth contact surface that faces the hard disk, and the heat conduction member is connected to the heat sink.

Heat generated when the hard disk works can be transferred to the heat conduction member, and then transferred to the heat sink through the heat conduction member, so as to effectively dissipate heat from the hard disk.

In a possible implementation, the heat conduction member is a heat pipe, to improve efficiency of heat transfer between the hard disk and the heat conduction member, and further improve efficiency of heat transfer between the hard disk and the heat conduction component.

In a possible implementation, the heat conduction component further includes at least one contact member, and the contact member is located on at least one of the third contact surface and the fourth contact surface on which the heat conduction member exists. The first contact surface is located on a side that is of the contact member and that is away from the body, and is in contact with the contact member.

Heat generated when the hard disk works may be transferred to the contact member, then transferred to the heat conduction member through the contact member, and finally transferred to the heat sink through the heat conduction member, to effectively dissipate heat from the hard disk.

In a possible implementation, the contact member is a spring plate, to implement plugging and unplugging of the hard disk by using the spring plate, which can not only increase effective contact area between the hard disk and the heat conduction component, but also achieve better contact between the hard disk and the heat conduction component, so that heat of the hard disk can be transferred to the heat sink through heat conduction component more efficiently, thereby effectively dissipating heat from the hard disk.

In a possible implementation, the heat dissipation apparatus further includes a casing. A through groove is disposed on the casing, the heat sink is disposed on a side of the casing, and is disposed opposite to the through groove. The plurality of heat conduction components pass through the through groove, and portions that are of the plurality of heat conduction components and that extend out of the through groove are connected to the heat sink.

In a possible implementation, the heat sink is a cold plate.

In a possible implementation, the heat sink is provided with a receiving chamber and a plurality of insertion ports, the receiving chamber accommodates a cooling medium, the plurality of insertion ports are in communication with the receiving chamber, one end of each heat conduction component is inserted into one insertion port, extends to the receiving chamber, and is immersed in the cooling medium.

According to a second aspect, this application provides an electronic device, including at least one hard disk and any one of the foregoing heat dissipation apparatuses, where each hard disk is plugged into one plug interface.

In the electronic device shown in this application, heat generated when the hard disk works may be transferred to the heat conduction component, and then to the heat sink through the heat conduction component. This can effectively improve efficiency of heat conduction between the heat sink and the hard disk, improve heat dissipation performance of the heat sink for the hard disk, and implement effective heat dissipation for the hard disk, so that the electronic device supports deployment of high-density hard disks and further implements heat dissipation for the high-power hard disks.

In a possible implementation, the electronic device further includes a hard disk backplane. The hard disk backplane is located on a side that is of the heat sink and that faces the plurality of heat conduction components, and is electrically connected to the at least one hard disk. The hard disk can work based on an electrical signal provided by the hard disk backplane.

In a possible implementation, avoidance space is disposed on the hard disk backplane, the avoidance space penetrates the hard disk backplane in a thickness direction of the hard disk backplane, and the plurality of heat conduction components pass through the avoidance space.

### BRIEF DESCRIPTION OF DRAWINGS

To describe the technical solutions in embodiments of this application more clearly, the following describes the accompanying drawings required in the embodiments of this application.
FIG. 1 is a schematic diagram of a structure of an electronic device according to an embodiment of this application;
FIG. 2 is a schematic diagram of a structure of a hard disk in the electronic device shown in FIG. 1;
FIG. 3 is a schematic diagram of a structure of a second heat dissipation apparatus in the electronic device shown in FIG. 1;
FIG. 4 is a schematic diagram of an exploded structure of the second heat dissipation apparatus shown in FIG. 3;
FIG. 5 is a schematic diagram of a structure of a plurality of heat conduction components in the second heat dissipation apparatus shown in FIG. 3;
FIG. 6 is a schematic diagram of a structure of a heat conduction component shown in FIG. 5 in a first implementation;
FIG. 7 is a schematic diagram of an exploded structure of the heat conduction component shown in FIG. 6;
FIG. 8a is a schematic diagram of a structure of a heat conduction component shown in FIG. 5 in a second implementation;
FIG. 8b is a schematic diagram of a structure of the heat conduction component shown in FIG. 8a at another angle;
FIG. 9a is a schematic diagram of an exploded structure of the heat conduction component shown in FIG. 8a;
FIG. 9b is a schematic diagram of an exploded structure of the heat conduction component shown in FIG. 8b;
FIG. 10a is a schematic diagram of a structure of a heat conduction component shown in FIG. 5 in a third implementation;
FIG. 10b is a schematic diagram of a structure of the heat conduction component shown in FIG. 10a at another angle;
FIG. 11a is a schematic diagram of an exploded structure of the heat conduction component shown in FIG. 10a;
FIG. 11b is a schematic diagram of an exploded structure of the heat conduction component shown in FIG. 10b;
FIG. 12 is a schematic diagram of an assembly structure of a plurality of hard disks, a hard disk backplane, and a second heat dissipation apparatus in the electronic device shown in FIG. 1; and
FIG. 13 is a schematic diagram of an assembly structure of a heat sink and a heat conduction component of a second heat dissipation apparatus in a second electronic device according to an embodiment of this application.

### DESCRIPTION OF EMBODIMENTS

The following clearly describes the technical solutions in embodiments of this application with reference to the accompanying drawings in embodiments of this application.

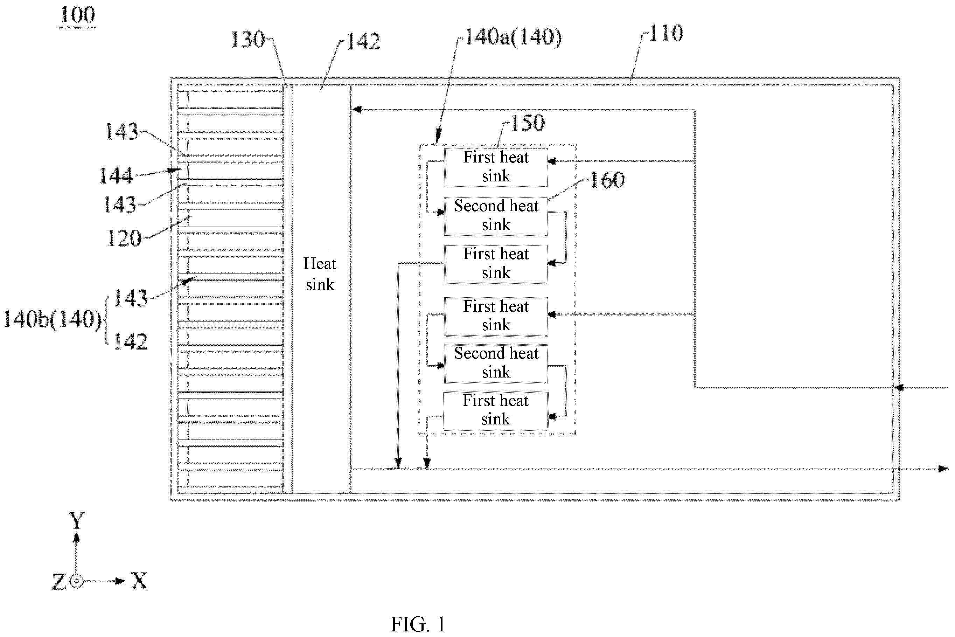

FIG. 1 is a schematic diagram of a structure of an electronic device 100 according to an embodiment of this application. Solid lines with arrows shown in FIG. 1 are flow paths of cooling medium.

The embodiment of this application provides the electronic device 100, and the electronic device 100 may be a device that needs information storage, such as a computer, a router, a switch, and a server. An example in which the electronic device 100 is a server is used for description in the following. For ease of description, a length direction of the electronic device 100 is defined as an X-axis direction, a width direction of the electronic device 100 is defined as a Y-axis direction, a height direction of the electronic device 100 is defined as a Z-axis direction, and the X-axis direction, the Y-axis direction, and the Z-axis direction are perpendicular to each other.

The electronic device 100 includes a housing 110, a memory module (not shown in the figure), a processor (not shown in the figure), hard disks 120, a hard disk backplane 130, and heat dissipation apparatuses 140. The memory module, the processor, the hard disks 120, the hard disk backplane 130, and the heat dissipation apparatuses 140 are all installed inside the housing 110. There are two heat dissipation apparatuses 140 and a plurality of hard disks 120. The two heat dissipation apparatuses 140 are a first heat dissipation apparatus 140a and a second heat dissipation apparatus 140b. The first heat dissipation apparatus 140a is configured to dissipate heat from the memory module and the processor, and the second heat dissipation apparatus 140b is configured to dissipate heat from the plurality of hard disks 120. It should be noted that "a plurality of" mentioned in embodiments of this application refers to two or more.

The memory module, the processor, and the first heat dissipation apparatus 140a are all located on a right side of the electronic device 100. The first heat dissipation apparatus 140a may conduct heat generated when the memory module and the processor work to the outside of the housing 110, so as to dissipate heat from the memory module and the processor. The processor may be a central processing unit (CPU, central processing unit).

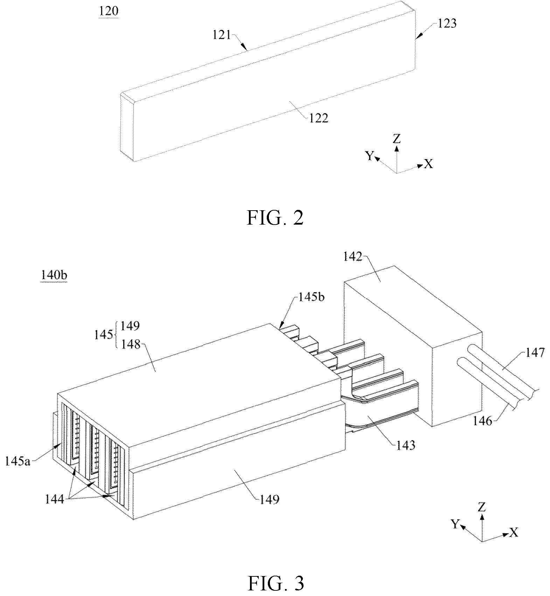

It should be understood that, in embodiments of this application, orientation words "top", "bottom", "left", "right", "front", "rear", and the like mentioned for describing the electronic device 100 are all described based on the directions shown in FIG. 3, with the positive Z-axis direction being "top", the negative Z-axis direction being "bottom", the negative X-axis direction being "left", the positive X-axis direction being "right", the positive Y-axis direction being "front", and the negative Y-axis direction being "rear", without imposing limitations on an actual application scenario of the second heat dissipation apparatus 140b.

In this embodiment, the first heat dissipation apparatus 140a includes a first heat sink 150 and a second heat sink 160. The first heat sink 150 is configured to dissipate heat from the memory module, and the second heat sink 160 is configured to dissipate heat from the processor. Both the first heat sink 150 and the second heat sink 160 are cold plates. It should be understood that the cold plate is a sealed heat sink that can contain the flow of liquid, and is usually fitted to a heat generating component by using a heat conducting interface material, so as to dissipate heat generated by the heat generating component. In some other embodiments, the first heat sink 150 and/or the second heat sink 160 may alternatively be other components capable of dissipating heat. This is not specifically limited in this application.

For example, there are four first heat sinks 150 and two second heat sinks 160. Every two first heat sinks 150 and one second heat sink 160 form a heat sink group (not marked in the figure). In some other embodiments, there may be one, two, three, or more than five first heat sinks 150, and/or there may be one or more than three second heat sinks 160.

The plurality of hard disks 120, the hard disk backplane 130, and the second heat dissipation apparatus 140b are all located on one side of the electronic device 100. In this embodiment, the second heat dissipation apparatus 140b includes a plurality of heat conduction components 143 and a heat sink 142. In the Y-axis direction, the plurality of heat conduction components 143 are arranged at intervals. A plug interface 144 is formed between two adjacent heat conduction components 143. Each plug interface 144 is used for one hard disk 120 to be plugged in. The heat sink 142 is connected to the plurality of heat conduction components 143. The heat sink 142 is a cold plate. The hard disk backplane 130 is located on a side that is of the heat sink 142 and that is away from the first heat dissipation apparatus 140a, and the hard disk backplane 130 is disposed facing the plurality of plug interfaces 144. The plurality of hard disks 120 are plugged into the plurality of plug interfaces 144 in a one-to-one manner, and are electrically connected to the hard disk backplane 130.

The plurality of hard disks 120 may work based on electrical signals provided by the hard disk backplane 130. Heat generated when each hard disk 120 works may be transmitted to the heat sink 142 through two heat conduction components 143. The heat sink 142 transmits the heat to the outside of the housing 110, thereby implementing heat dissipation of the plurality of hard disks 120, to resolve a heat dissipation problem of the high-density and high-power hard disks 120 in the electronic device 100, and reduce a working load of a cooling fan (not shown in the figure) in the electronic device 100.

In some other embodiments, the electronic device 100 may alternatively include one or more hard disks 120 and one or more virtual hard disks (not shown in the figure), and the one or more hard disks 120 and the one or more virtual hard disks are plugged into the plurality of plug interfaces 144 in a one-to-one manner. It should be understood that the virtual hard disk is a component that has the same external structure as the hard disk 120 but cannot work based on an electric signal provided by the hard disk backplane 130.

The following describes an internal flow path of cooling medium in the electronic device 100 by using the paths of the cooling medium shown in FIG. 1 as an example.

After the cooling medium such as coolant or cooling gas enters the inside of the housing 110, the cooling medium is split into three paths of cooling medium. One path of cooling medium directly enters the heat sink 142 of the second heat dissipation apparatus 140b, takes away heat transmitted to the heat sink 142 through the plurality of heat conduction components 143, and exits the housing 110, so as to dissipate heat from the plurality of hard disks 120. The other two paths of cooling medium flow through two heat sink groups respectively, and each path sequentially passes through a first heat sink 150, a second heat sink 160, and a first heat sink 150 of the heat sink group, and then flows out of the housing 110, so as to implement heat dissipation for the memory module and the processor.

It may be understood that, in this embodiment, the two heat sink groups of the first heat dissipation apparatus 140a and the heat sink 142 of the second heat dissipation apparatus 140b are disposed in parallel, and the three paths of cooling medium respectively flow through the two heat sink groups and the heat sink 142 of the second heat dissipation apparatus 140b, so that heat dissipation for the memory module, the processor, and the hard disks 120 can be maximized.

In some other embodiments, the two heat sink groups of the first heat dissipation apparatus 140a may alternatively be disposed in series. In this case, after the cooling medium enters the inside of the housing 110, the cooling medium is split into two paths of cooling medium, and the two paths of cooling medium respectively flow through the first heat dissipation apparatus 140a and the second heat dissipation apparatus 140b. Similarly, heat dissipation for the memory module, the processor, and the hard disks 120 can be implemented. This application sets no specific limitation on a connection manner of the two heat sink groups of the first heat dissipation apparatus 140a.

Refer to FIG. 1 and FIG. 2. FIG. 2 is a schematic diagram of a structure of the hard disk 120 in the electronic device 100 shown in FIG. 1.

In this embodiment, the hard disk 120 is in a rectangular shape. The hard disk 120 includes a first contact surface 121, a second contact surface 122, and a connection surface 123. The first contact surface 121 and the second contact surface 122 are disposed opposite to each other, and are respectively used to be in contact with two adjacent heat conduction components 143, so as to increase a contact area between the hard disk 120 and the heat conduction components 143, and to quickly transfer heat generated to the two heat conduction components 143when the hard disk 120 works, thereby improving efficiency of heat transfer between the hard disk 120 and the heat conduction components 143, and improving heat dissipation performance of the second heat dissipation apparatus 140b for the hard disk 120. Both the first contact surface 121 and the second contact surface 122 are parallel to an extension direction (in the X-axis direction shown in the figure) of the hard disk 120, so as to ensure that a surface with a largest area of the hard disk 120 is in contact with the heat conduction component 143, and to increase a contact area between the hard disk 120 and the heat conduction component 143. The connection surface 123 is connected between the first contact surface 121 and the second contact surface 122, and is used to electrically connect to the hard disk backplane 130, so as to implement electrical connection between the hard disk 120 and the hard disk backplane 130.

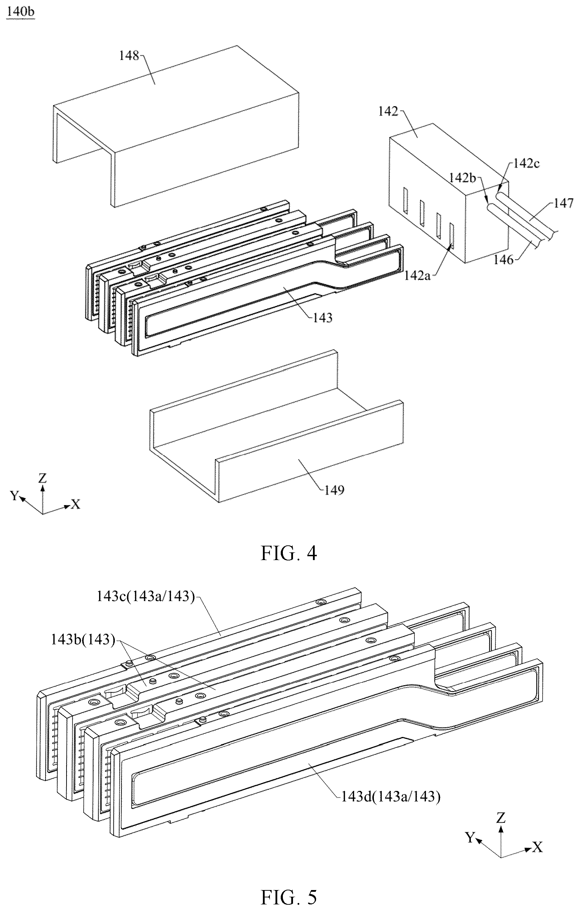

Refer to FIG. 3 and FIG. 4. FIG. 3 is a schematic diagram of a structure of the second heat dissipation apparatus 140b in the electronic device 100 shown in FIG. 1, and FIG. 4 is a schematic diagram of an exploded structure of the second heat dissipation apparatus 140b shown in FIG. 3. FIG. 3 and FIG. 4 merely show four heat conduction components 143 of the second heat dissipation apparatus 140b.

The second heat dissipation apparatus 140b further includes a casing 145, an inlet pipe 146, and an outlet pipe 147. A through groove (not marked in the figure) is disposed on the casing 145, and the through groove accommodates a plurality of heat conduction components 143 to protect the plurality of heat conduction components 143. Both the inlet pipe 146 and the outlet pipe 147 are in communication with the heat sink 142. The inlet pipe 146 inputs a cooling medium outside the housing 110 (as shown in FIG. 1) to the heat sink 142, and the outlet pipe 147 outputs the cooling medium from the heat sink 142 to the outside of the housing 110, so as to transmit heat to the outside of the housing 110, thereby implementing heat dissipation for the plurality of hard disks 120.

The casing 145 includes a first casing 148 and a second casing 149. Both the first casing 148 and the second casing 149 are fixedly connected to the plurality of heat conduction components 143, and jointly form the through groove through enclosing. A left end face of the first casing 148 and a left end face of the second casing 149 jointly form a first opening 145a through enclosing, and a right end face of the second casing 149 and a right end face of the second casing 149 jointly form a second opening 145b through enclosing. For example, both the first casing 148 and the second casing 149 may be fixedly connected to the plurality of heat conduction components 143 by using fasteners such as screws or bolts. In some other embodiments, the first casing 148 and the second casing 149 may alternatively be fixedly connected to the plurality of heat conduction components 143 in a welding or bonding manner. This is not specifically limited in this application.

The heat sink 142 is disposed on a side of the casing 145, and is spaced apart from the casing 145. Specifically, the heat sink 142 is located on a side that is of the second opening 145b and that is away from the first opening 145a, and is disposed facing the through groove. The heat sink 142 is provided with an insertion port 142a, a receiving chamber (not shown in the figure), an inlet port 142b, and an outlet port 142c. An opening of the insertion port 142a is located on a surface that is of the heat sink 142 and that faces the casing 145. There are a plurality of insertion ports 142a. The plurality of insertion ports 142a are arranged at intervals along the Y-axis direction, and are disposed facing the plurality of heat conduction components 143 in a one-to-one manner. For example, there are four insertion ports 142a. In some other embodiments, there may alternatively be one, two, three, or more than five insertion ports 142a. This is not specifically limited in this application.

The receiving chamber is disposed inside the heat sink 142, and is used to receive a cooling medium. A plurality of heat dissipation fins may be disposed in the receiving chamber, so as to increase heat dissipation efficiency of the heat sink 142. The inlet port 142b and outlet port 142c are arranged at an interval, and both are in communication with the receiving chamber. Specifically, both openings of the inlet port 142b and the outlet port 142c are disposed on a side surface of the heat sink 142. The inlet pipe 146 is inserted into the inlet port 142b to input a cooling medium outside the housing 110 to the receiving chamber through the inlet port 142b. The outlet pipe 147 is inserted into the outlet port 142c to output the cooling medium in the receiving chamber to the outside of the housing 110 through the outlet port 142c.

Refer to FIG. 3 and FIG. 5. FIG. 5 is a schematic diagram of a structure of the plurality of heat conduction components 143 in the second heat dissipation apparatus 140b shown in FIG. 3.

The plurality of heat conduction components 143 pass through the through groove, and portions of the plurality of heat conduction components 143 that extend out of the through groove are connected to the heat sink 142. Specifically, in each heat conduction component 143, a portion of the heat conduction component 143 is located between the first opening 145a and the second opening 145b. A portion of the heat conduction component 143 extends out of the second opening 145b, and is inserted into the insertion port 142a and connected to the heat sink 142. One plug interface 144 is formed between two adj acent heat conduction components 143, and a plurality of plug interfaces 144 are in communication with the first opening 145a and the second opening 145b. Each plug interface 144 is used for one hard disk 120 to be plugged in.

It should be noted that structures of the plurality of heat conduction components 143 may be one or more of the following heat conduction components 143. The structures of the plurality of heat conduction components 143 may be the same or different. The following specifically describes several different structures of the heat conduction component 143.

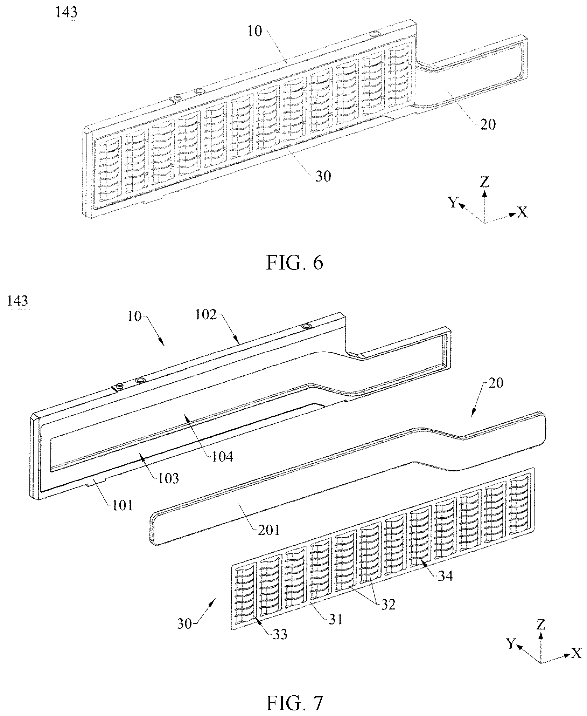

Refer to FIG. 6 and FIG. 7. FIG. 6 is a schematic diagram of a structure of a heat conduction component 143 shown in FIG. 5 in a first implementation. FIG. 7 is a schematic diagram of an exploded structure of the heat conduction component 143 shown in FIG. 6.

In this embodiment, the heat conduction component 143 extends in the X-axis direction. The heat conduction component 143 includes a body 10, a heat conduction member 20, and a contact member 30. Both the heat conduction member 20 and the contact member 30 are installed on the body 10.

The body 10 includes a third contact surface 101 and a fourth contact surface 102, and the third contact surface 101 and the fourth contact surface 102 are disposed opposite to each other. The third contact surface 101 is a surface of the body 10 that faces the negative direction of the Y-axis, and the fourth contact surface 102 is a surface of the body 10 that faces the positive direction of the Y-axis. The body 10 is provided with a first mounting groove 103 and a second mounting groove 104. An opening of the first mounting groove 103 is located on the third contact surface 101. The first mounting groove 103 is recessed in a direction from the third contact surface 101 to the fourth contact surface 102 (the Y-axis positive direction shown in the figure). An opening of the second mounting groove 104 is located on a groove bottom wall of the first mounting groove 103. The second mounting groove 104 is recessed in a direction from the groove bottom wall of the first mounting groove 103 to the fourth contact surface 102 (the Y-axis positive direction shown in the figure). A material of the body 10 may be a heat conducting material. For example, the material of the body 10 is a metal material with a relatively high heat conductivity coefficient such as copper or aluminum.

The heat conduction member 20 is located on one of the third contact surface 101 and the fourth contact surface 102. In this implementation, the heat conduction member 20 is located on the third contact surface 101. Specifically, the heat conduction member 20 is installed in the second mounting groove 104. The heat conduction member 20 includes an auxiliary surface 201 facing the same direction as the opening direction of the second mounting groove 104. The auxiliary surface 201 is flush with the groove bottom wall of the first mounting groove 103. The heat conduction member 20 may use a size of the body 10 in the Y-axis direction, which helps reduce a size of the heat conduction component 143 in the Y-axis direction.

In some other implementations, the auxiliary surface 201 may not be flush with the groove bottom wall of the first mounting groove 103. For example, the auxiliary surface 201 is recessed relative to the groove bottom wall of the first mounting groove 103, or the auxiliary surface 201 protrudes relative to the groove bottom wall of the first mounting groove 103. This is not specifically limited in this application.

The heat conduction member 20 is a heat pipe, to ensure high heat conductivity of the heat conduction member 20. For example, the heat conduction member 20 may be installed in the second mounting groove 104 through welding. It should be understood that the heat pipe is a heat transfer element with extremely high heat conductivity, and heat is transmitted through evaporation and condensation of liquid in the fully enclosed vacuum pipe. For example, the heat pipe is a long-strip-shaped flat tube made of copper. In some other embodiments, the heat conduction member 20 may alternatively be another heat conduction device with high heat conductivity. This is not specifically limited in this application.

The contact member 30 is located on a contact surface that is in the third contact surface 101 and the fourth contact surface 102 where the heat conduction member 20 exists. In this implementation, the contact member 30 is located on the third contact surface 101. Specifically, the contact member 30 is installed in the first mounting groove 103, and is in contact with the auxiliary surface 201 of the heat conduction member 20. The contact member 30 is used to be in contact with the hard disk 120 (as shown in FIG. 2). In this case, the first contact surface 121 of the hard disk 120 is located on a side that is of the contact member 30 and that is away from the body 10, and is in contact with the contact member 30.

In this embodiment, the contact member 30 is a spring plate. In an example, the contact member 30 is installed on the body 10 through welding. A material of the contact member 30 is a heat conducting material. For example, the material of the contact member 30 is a material with a relatively high heat conductivity coefficient such as beryllium copper.

Specifically, the contact member 30 includes a body part 31 and a spring plate part 32, and the spring plate part 32 is fixedly connected to the body part 31. The spring plate part 32 is used to be in contact with the hard disk 120. The body part 31 is installed in the first mounting groove 103, and is in contact with the auxiliary surface 201 of the heat conduction member 20. A plurality of mounting holes 33 are disposed on the body part 31, and each mounting hole 33 penetrates the body part 31 in a thickness direction (the Y-axis direction shown in the figure) of the body part 31. The plurality of mounting holes 33 are arranged at intervals in an extension direction (the X-axis direction shown in the figure) of the body part 31.

There are a plurality of spring plate parts 32. Each spring plate part 32 is fixedly connected to the left edge of one mounting hole 33. Each spring plate part 32 extends in the positive X-axis direction, and is spaced from the right edge of the mounting hole 33. Specifically, each spring plate part 32 protrudes, from a surface that is the body part 31 and that is away from the heat conduction member 20. Each spring plate part 32 is in a wave shape, to increase elasticity of the spring plate part 32. In addition, a plurality of through holes 34 are disposed on each spring plate part 32. The plurality of through holes 34 are arranged at intervals in the Z-axis direction. An extension direction of each through hole 34 is parallel to an extension direction of the spring plate part 32, to increase elasticity of the spring plate part 32.

Refer to FIG. 2 and FIG. 3. In this embodiment, portions of the body 10 and the heat conduction member 20 that extend out of the second opening 145b are inserted into the insertion port 142a, and are connected to the heat sink 142. Because the material of the body 10 is a material with a relatively high heat conductivity coefficient, heat generated when the hard disk 120 works may be transmitted to the heat conduction member 20 and the body 10 through the contact member 30, and then to the heat sink 142 through the heat conduction member 20 and the body 10, thereby implementing heat dissipation for the hard disk 120.

In some other embodiments, the heat conduction component 143 may alternatively not include the contact member 30. In this case, heat generated when the hard disk 120 works may be transferred to the heat conduction member 20 and transferred to the body 10, and then to the heat sink 142 through the heat conduction member 20 and the body 10. Alternatively, the hard disk is in contact with the surface on which no heat conduction member 20 exists, for example, the hard disk is in contact with the fourth contact surface 102, and the heat conduction member 20 is located on the third contact surface 101. In this case, heat generated when the hard disk 120 works may be transferred from the body 10 to the heat conduction member 20, and then is transferred to the heat sink 142 through the heat conduction member 20 and the body 10.

Alternatively, the material of the body 10 may be a non-heat conducting material. The heat conduction member 20 is located on one of the third contact surface 101 and the fourth contact surface 102 that faces the hard disk 120, and the contact member 30 is located on one of the third contact surface 101 and the fourth contact surface 102 where the heat conduction member 20 exists. In this case, heat generated when the hard disk 120 works may be transferred to the heat conduction member 20 through the contact member 30, and then to the heat sink 142 through the heat conduction member 20, thereby implementing heat dissipation for the hard disk 120.

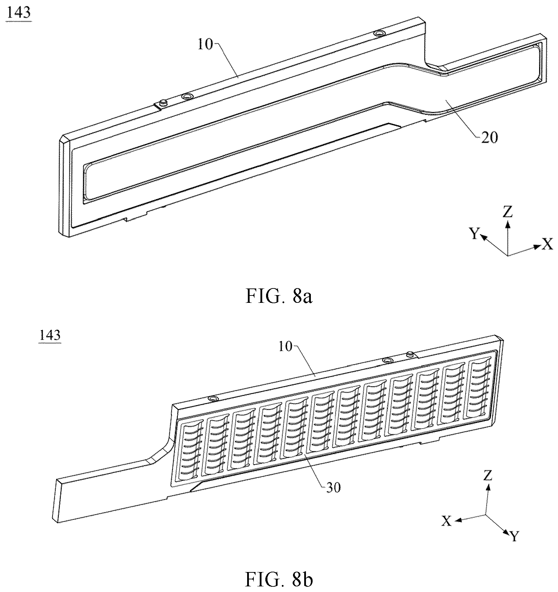

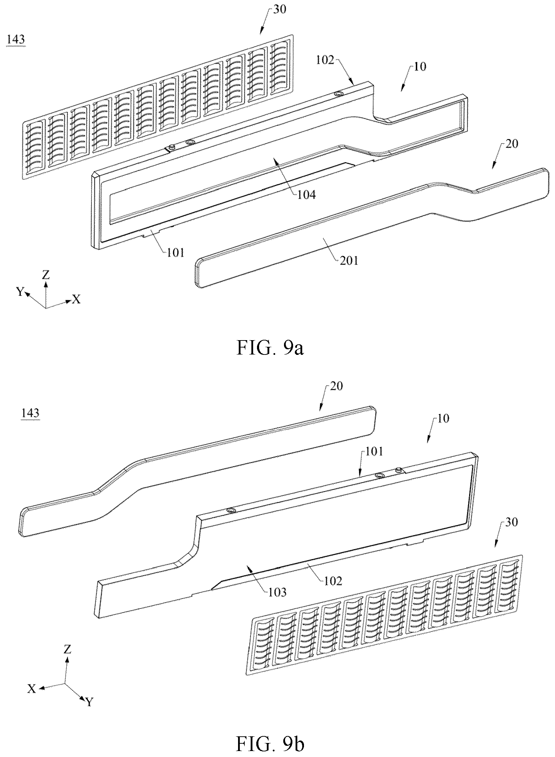

Refer to FIG. 8a, FIG. 8b, FIG. 9a, and FIG. 9b. FIG. 8a is a schematic diagram of a structure of the heat conduction component 143 shown in FIG. 5 in a second implementation. FIG. 8b is a schematic diagram of a structure of the heat conduction component 143 shown in FIG. 8a at another angle. FIG. 9a is a schematic diagram of an exploded structure of the heat conduction component 143 shown in FIG. 8a. FIG. 9b is a schematic diagram of an exploded structure of the heat conduction component 143 shown in FIG. 8b.

The heat conduction component 143 includes a body 10, a heat conduction member 20, and a contact member 30. Both the heat conduction member 20 and the contact member 30 are installed on the body 10. A difference between the heat conduction component 143 shown in this embodiment and the heat conduction component 143 shown in the foregoing first implementation is that the contact member 30 and the heat conduction member are located on different contact surfaces. For example, an opening of the first mounting groove 103 is located on the fourth contact surface 102. The first mounting groove 103 is recessed in a direction from the fourth contact surface 102 to the third contact surface 101 (the Y-axis negative direction shown in the figure). An opening of the second mounting groove 104 is located on the third contact surface 101. The second mounting groove 104 is recessed in a direction from the third contact surface 101 to the fourth contact surface 102 (the Y-axis positive direction shown in the figure). Structures of the body 10, the heat conduction member 20, and the contact member 30 of the heat conduction component 143 are basically the same as the structures of the body 10, the heat conduction member 20, and the contact member 30 of the heat conduction component 143 in the foregoing first implementation, and details are not described herein again.

Refer to FIG. 2 and FIG. 3. In this embodiment, portions of the body 10 and the heat conduction member 20 that extend out of the second opening 145b are inserted into the insertion port 142a, and are connected to the heat sink 142. Similar to the first embodiment, a material of the body 10 may be a heat conducting material. When the hard disk 120 is in contact with a side where the contact member exists, heat generated when the hard disk 120 works may be transferred to the body 10 through the contact member 30, then to the heat conduction member 20 through the body 10, and finally to the heat sink 142 through the body 10 and the heat conduction member 20, thereby implementing heat dissipation for the hard disk 120. When the hard disk 120 is in contact with a side where the heat conduction member exists, heat generated when the hard disk 120 works may be transferred to the body 10 through the heat conduction member 20, then to the contact member 30 through the body 10, and finally to the heat sink 142 through the body 10 and the heat conduction member 20, thereby implementing heat dissipation for the hard disk 120.

Alternatively, the material of the body 10 may be a non-heat conducting material. The heat conduction member 20 is located on one of the third contact surface 101 and the fourth contact surface 102 that faces the hard disk 120, and the contact part 30 is located on the other contact surface. In this case, heat generated when the hard disk 120 works may be transferred to the heat sink 142 through the heat conduction member 20, thereby implementing heat dissipation for the hard disk 120.

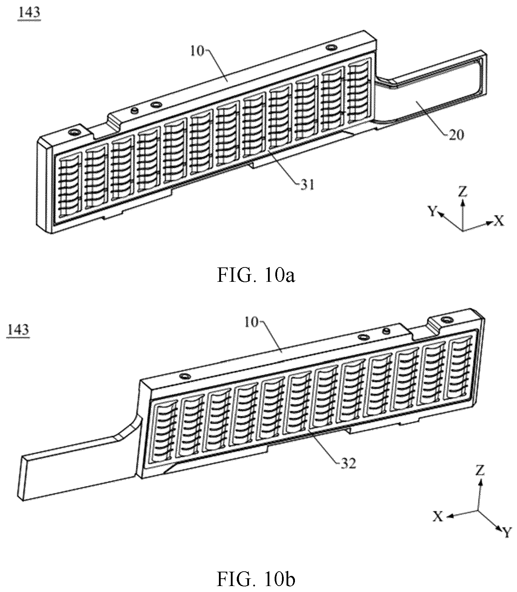

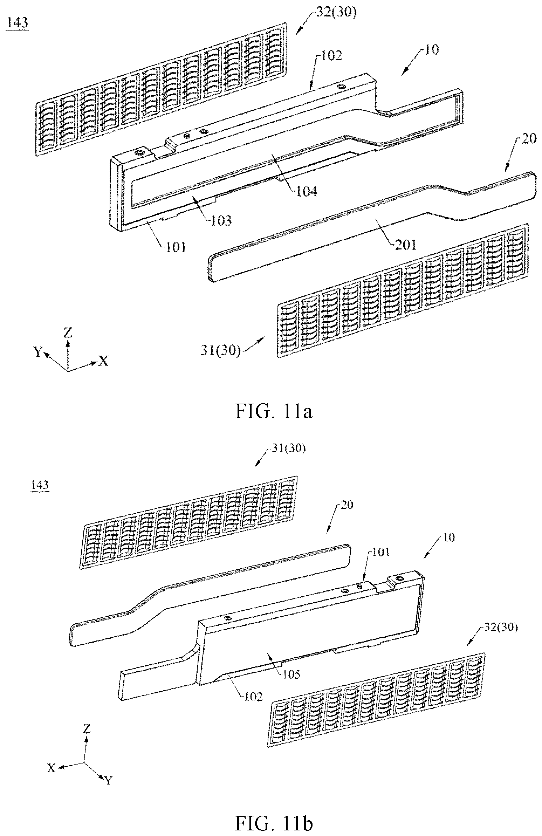

Refer to FIG. 10a, FIG. 10b, FIG. 11a, and FIG. 11b. FIG. 10a is a schematic diagram of a structure of the heat conduction component 143 shown in FIG. 5 in a third implementation. FIG. 10b is a schematic diagram of a structure of the heat conduction component 143 shown in FIG. 10a at another angle. FIG. 11a is a schematic diagram of an exploded structure of the heat conduction component 143 shown in FIG. 10a. FIG. 11b is a schematic diagram of an exploded structure of the heat conduction component 143 shown in FIG. 10b.

The heat conduction component 143 includes a body 10, a heat conduction member 20, and two contact members 30. Both the heat conduction member 20 and the contact members 30 are installed on the body 10. A difference between the heat conduction component 143 shown in this embodiment and the heat conduction component 143 shown in the foregoing first implementation lies in that there are two contact members 30 in this embodiment. The two contact members 30 are a first contact member 31 and a second contact member 32, the first contact member 31 is located on a third contact surface 101, and the second contact member 32 is located on a fourth contact surface 102. Structures of the body 10, the heat conduction member 20, and the contact members 30 of the heat conduction component 143 are basically the same as the structures of the body 10, the heat conduction member 20, and the contact member 30 in the foregoing first implementation, and details are not described herein again.

In addition, the body 10 is further provided with a third mounting groove 105, and an opening of the third mounting groove 105 is located on the fourth contact surface 102. The third mounting groove 105 is recessed in a direction from the fourth contact surface 102 to the third contact surface 101 (the Y-axis negative direction shown in the figure). The first contact member 31 is installed in the first mounting groove 103, and is in contact with an auxiliary surface 201 of the heat conduction member 20. The second contact member 32 is installed in the third mounting groove 105.

Refer to FIG. 2 and FIG. 3. In this embodiment, portions of the body 10 and the heat conduction member 20 that extend out of the second opening 145b are inserted into the insertion port 142a, and are connected to the heat sink 142. Similar to the first embodiment, a material of the body 10 may be a heat conducting material. When the hard disk 120 is in contact with the first contact member 31, heat generated when the hard disk 120 works may be transferred to the body 10 and the heat conduction member 20 through the first contact member 31, and then to the heat sink 142 through the body 10 and the heat conduction member 20, thereby implementing heat dissipation for the hard disk 120 on the rear side of the heat conduction component 143. When the hard disk 120 is in contact with the second contact member 32, heat generated when the hard disk 120 works may be transferred to the body 10 through the second contact member 32, and then to the heat sink 142 through the body 10 and the heat conduction member 20, thereby implementing heat dissipation for the hard disk 120 on the front side of the heat conduction component 143.

Alternatively, the material of the body 10 may be a non-heat conducting material. The heat conduction member 20 is located on at least one of the third contact surface 101 and the fourth contact surface 102 that faces the hard disk 120, and the contact members 30 are located on two of the third contact surface 101 and the fourth contact surface 102. In this case, heat generated when the hard disk 120 works may be transferred to the heat conduction member 20 through the contact member 30, and then to the heat sink 142 through the heat conduction member 20, thereby implementing heat dissipation for the hard disk 120.

In some other implementations, there may be two heat conduction members 20, and the two heat conduction members 20 are a first heat conduction member and a second heat conduction member. The body 10 may be further provided with a fourth mounting groove (not shown in the figure), and an opening of the fourth mounting groove is located on a groove bottom wall of the third mounting groove 105. The fourth mounting groove is recessed in a direction from the groove bottom wall of the third mounting groove 105 to the third contact surface 101 (the Y-axis negative direction shown in the figure). The first heat conduction member is installed in the second mounting groove 104, the second heat conduction member is installed in the fourth mounting groove, and the second contact member 32 is installed in the third mounting groove 105, and the second contact member 32 is in contact with the second heat conduction member. In this case, when the hard disk 120 is in contact with the first contact member 31, heat generated when the hard disk 120 works may be transferred to the first heat conduction member and the body 10 through the first contact member 31, and may be further transferred to the second heat conduction member through the body 10 and then to the heat sink 142 through the body 10, the first heat conduction member, and the second heat conduction member, to implement heat dissipation for the hard disk 120. When the hard disk 120 is in contact with the second contact member 32, heat generated when the hard disk 120 works may be transferred to the second heat conduction member and the body 10 through the second contact member 32, and may be further transferred to the first heat conduction member through the body 10 and then to the heat sink 142 through the body 10, the first heat conduction member, and the second heat conduction member, thereby implementing heat dissipation for the hard disk 120.

Alternatively, when there may be two heat conduction members 20, the heat conduction component 143 may not include the first contact member 31, or may not include the second contact member 32.

It should be noted that when there are two heat conduction members 20, because the heat conduction members are disposed on both contact surfaces of the body, the body may be a heat conducting material or may be a non-heat conducting material, and the hard disk 120 may be in contact with either of the contact surfaces of the heat conduction component.

In conclusion, the heat conduction component 143 may include the body and at least one heat conduction member. The body includes the third contact surface and the fourth contact surface that are disposed opposite to each other, and portions of the body and portions of the heat conduction member that extend out of the second opening 145b are inserted into the insertion port 142a, and are connected to the heat sink 142.

When the material of the body is a heat conducting material, the heat conduction member is located on at least one of the third contact surface and the fourth contact surface, and the heat conduction member is connected to the heat sink. For example, the heat conduction member may be a heat pipe. The heat conduction component may further include at least one contact member, and the contact member is located on at least one of the third contact surface and the fourth contact surface.

When the heat conduction member exists on a contact surface on which the contact member is located, the contact member is located on a side that is of the heat conduction member and that is away from the body, and is in contact with the heat conduction member. Alternatively, when there is no heat conduction member on the contact surface on which the contact member is located, the contact member is directly in contact with the body. For example, the contact member may be a spring plate.

When the material of the body is not a heat conducting material, the heat conduction member is located on at least one of the third contact surface and the fourth contact surface that faces the hard disk, and the heat conduction member is connected to the heat sink. For example, the heat conduction member may be a heat pipe. The heat conduction component may further include at least one contact member, and the contact member is located on at least one of the third contact surface and the fourth contact surface on which the heat conduction member exists. The contact member is located on a side that is of the heat conduction member and that is away from the body, and is in contact with the heat conduction member. For example, the contact member may be a spring plate.

Refer to FIG. 5. In this embodiment, the plurality of heat conduction components 143 include two first heat conduction components 143a and at least one heat conduction component 143b. It should be understood that division of the first heat conduction component 143a and the second heat conduction component 143b is based on a location of each heat conduction component 143. The two first heat conduction components 143a are heat conduction components 143 located on outermost sides, and the second heat conduction component 143b is a heat conduction component 143 located in the middle, and is located between the two first heat conduction components 143a.

Specifically, the two first heat conduction components 143a have a same structure. The two first heat conduction components 143a are respectively a first front heat conduction component 143c and a first rear heat conduction component 143d. The first front heat conduction component 143c is the headmost heat conduction component 143, and the first rear heat conduction component 143d is the backmost heat conduction component 143. The first front heat conduction component 143c uses the structure of the heat conduction component 143 shown in the foregoing first implementation, and the heat conduction member is disposed in a direction facing the hard disk, that is, is disposed backward. The first rear heat conduction component 143d also uses the structure of the heat conduction component 143 shown in the foregoing first implementation, and the heat conduction member is disposed in a direction facing the hard disk, that is, is disposed forward. The second heat conduction component 143b uses the structure of the heat conduction component 143 shown in the foregoing third implementation.

It may be understood that in some other embodiments, the first front heat conduction component 143c may alternatively use the structure of the heat conduction component 143 shown in the foregoing second or third implementation, and/or the first rear heat conduction component 143d may use the structure of the heat conduction component 143 shown in the foregoing first or third implementation, and/or the second heat conduction component 143b may use the structure of the heat conduction component 143 shown in the foregoing first or second implementation.

For example, there are two heat conduction components 143b. Portions that are of the two first heat conduction components 143a and that extend out of the second opening 145b are inserted into the four insertion ports 142a of the heat sink 142 respectively, and are connected to the heat sink 142. Portions that are of the two second heat conduction components 143b and that extend out of the second opening 145b are inserted into the four insertion ports 142a of the heat sink 142 respectively, and are connected to the heat sink 142. So the connection between the plurality of heat conduction components 143 and the heat sink 142 can be implemented. In some other embodiments, there may alternatively be one or at least three second heat conduction components 143b. This is not specifically limited in this application.

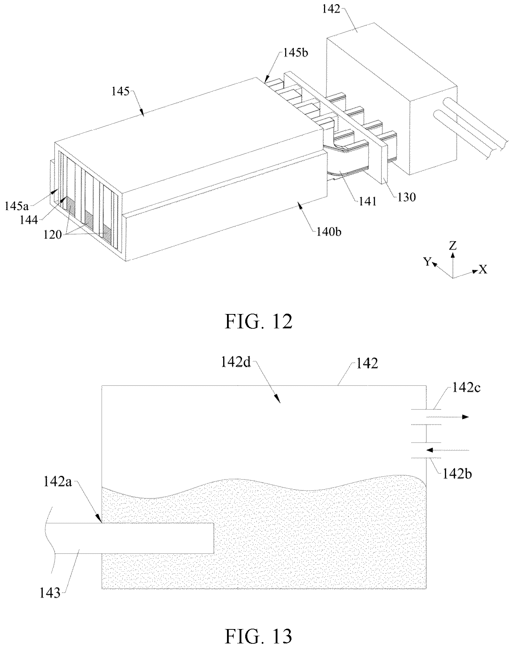

Refer to FIG. 2 and FIG. 12. FIG. 12 is a schematic diagram of an assembly structure of the plurality of hard disks 120, the hard disk backplane 130, and the second heat dissipation apparatus 140b in the electronic device 100 shown in FIG. 1.

The hard disk backplane 130 is located between the heat sink 142 and the casing 145, and is disposed at intervals from the heat sink 142 and the casing 145. Avoidance space (not shown in the figure) is disposed on the hard disk backplane 130, and the avoidance space penetrates the hard disk backplane 130 in a thickness direction (the X-axis direction shown in the figure) of the hard disk backplane 130. Specifically, portions of the plurality of heat conduction components 143 that extend out of the second opening 145b pass through the avoidance space. The hard disk backplane 130 is a circuit board.

The plurality of hard disks 120 are inserted into the plurality of plug interfaces 144 respectively from the first opening 145a, extend out of the second opening 145b, and are electrically connected to the hard disk backplane 130. Specifically, the first contact surface 121 and the second contact surface 122 of the hard disk 120 are respectively in contact with contact members of two adjacent heat conduction components 143, and the connection surface 123 is electrically connected to the hard disk backplane 130. The hard disk 120 may work and heat based on an electrical signal provided by the hard disk backplane 130, and heat of the hard disk 120 may be transferred to the heat conduction component 143 through the first contact member or the second contact member, and is transferred to the heat sink 142 through the heat conduction component 143, so as to effectively dissipate heat from the hard disk 120.

For a hard disk 120 located between two heat conduction components 143, a first contact surface 121 is in contact with a contact member 30 of one heat conduction component 143, and a second contact surface 122 is in contact with a contact member 30 of the other heat conduction component 143. It should be noted that, because the contact member of the heat conduction component 143 is a spring plate, when the hard disk 120 is plugged into the plug interface 144, plugging and unplugging of the hard disk 120 can be implemented by using the spring plate part 32a, and an effective contact area between the hard disk 120 and the heat conduction component 143 can be increased, so that the hard disk 120 and the heat conduction component 143 can be in better contact, and heat of the hard disk 120 can be transferred to the heat sink 142 through the heat conduction component 143 more efficiently, to implement effective heat dissipation for the hard disk 120. In this way, the electronic device 100 supports deployment of the high-density hard disks 120, and heat dissipation can be further implemented for the large-power hard disks 120.

Refer to FIG. 13. FIG. 13 is a schematic diagram of an assembly structure of a heat sink 142 and a heat conduction component 143 of a second heat dissipation apparatus in a second electronic device according to an embodiment of this application. Solid lines with arrows shown in FIG. 1 are flow paths of cooling medium.

A difference between the heat sink of the heat dissipation apparatus in the electronic device shown in this embodiment of this application and the heat sink 142 of the heat dissipation apparatus 140 in the electronic device 100 shown in the foregoing embodiment is that the heat sink 142 is an immersed heat sink. Specifically, an insertion port 142a of the heat sink 142 is in communication with a receiving chamber 142d. A cooling medium is accommodated in the receiving chamber 142d of the heat sink 142. A liquid level of the cooling medium is higher than the insertion port 142a. Both an inlet port 142b and an outlet port 142c of the heat sink 142 are higher than the liquid level of the cooling medium. A cooling medium enters the receiving chamber 142d through the inlet port 142b and is output from the receiving chamber 142d through the outlet port 142c, to replace the cooling medium in the receiving chamber 142d.

One end of the heat conduction component 143 is inserted into the insertion port 142a, extends into the receiving chamber 142d, and is immersed in the cooling medium. Heat generated when the hard disk 120 works is transferred to the cooling medium through the heat conduction component 143, and the heat is transferred to the outside through replacement of the cooling medium, thereby implementing heat dissipation for the hard disk 120.

In this embodiment, heat generated when the hard disk 120 works may be transferred to the heat conduction component 143 through a first contact surface 121 and a second contact surface 122, and then transferred to the heat sink 142 through the heat conduction component 143. This can effectively improve efficiency of heat conduction between the heat dissipation apparatus 140 and the hard disk 120, improve heat dissipation performance of the heat dissipation apparatus 140 for the hard disk 120, and implement effective heat dissipation for the hard disk 120, so that the electronic device 100 can further implement heat dissipation for high-power hard disks 120 while supporting deployment of the high-density hard disks 120.

The foregoing descriptions are merely specific implementations of this application, but are not intended to limit the protection scope of this application. Any change or replacement readily figured out by a person skilled in the art within the technical scope disclosed in this application shall fall within the protection scope of this application. Under non-conflicting circumstances, the embodiments of this application and features in the embodiments may be mutually combined. Therefore, the protection scope of this application shall be subject to the protection scope of the claims.

## Claims

1. A heat dissipation apparatus (140), comprising a heat sink (142) and a plurality of heat conduction components (143), wherein the plurality of heat conduction components (143) are all connected to the heat sink (142), the plurality of heat conduction components (143) are arranged at intervals, a plug interface (144) is formed between two adjacent heat conduction components (143), and the plug interface (144) is used for one hard disk (120) to be plugged in;
wherein the hard disk (120) comprises a first contact surface (121) and a second contact surface (122) that are disposed opposite to each other, and the first contact surface (121) and the second contact surface (122) are respectively in contact with two adjacent heat conduction components (143); wherein the heat dissipation apparatus is **characterized in that**:
the heat conduction component (143) comprises a body (10) and at least one heat conduction member (20), and a material of the body (10) is a heat conducting material, and the body (10) comprises a third contact surface (101) and a fourth contact surface (102) that are disposed opposite to each other, the heat conduction member (20) is located on at least one of the third contact surface (101) and the fourth contact surface (102), and the heat conduction member (20) is connected to the heat sink (142); or the heat conduction component (143) comprises a body (10) and at least one heat conduction member (20), and a material of the body (10) is not a heat conducting material, and the body (10) comprises a third contact surface (101) and a fourth contact surface (102) that are disposed opposite to each other, the heat conduction member (20) is located on at least one of the third contact surface (101) and the fourth contact surface (102) that faces the hard disk (120), and the heat conduction member (20) is connected to the heat sink (142).

2. The heat dissipation apparatus (140) according to claim 1, wherein the heat conduction member (20) is a heat pipe.

3. The heat dissipation apparatus (140) according to claim 1 or 2, wherein when the material of the body (10) is a heat conducting material, the heat conduction component (143) further comprises at least one contact member (30), and the contact member (30) is located on at least one of the third contact surface (101) and the fourth contact surface (102); and
when the heat conduction member (20) exists on a contact surface on which the contact member (30) is located, the contact member (30) is located on a side that is of the heat conduction member (20) and that is away from the body (10), and is in contact with the heat conduction member (20); or
when the heat conduction member (20) does not exist on the contact surface on which the contact member (30) is located, the contact member (30) is directly in contact with the body (10).

4. The heat dissipation apparatus (140) according to claim 1 or 3, wherein when the material of the body (10) is not a heat conducting material, the heat conduction component (143) further comprises at least one contact member (30), the contact member (30) is located on at least one of the third contact surface (101) and the fourth contact surface (102) on which the heat conduction member (20) exists, and the contact member (30) is located on a side that is of the heat conduction member (20) and that is away from the body (10), and is in contact with the heat conduction member (20).

5. The heat dissipation apparatus (140) according to claim 3 or 4, wherein the contact member (30) is a spring plate.

6. The heat dissipation apparatus (140) according to any one of claims 1 to 5, wherein the heat dissipation apparatus (140) further comprises a casing (145), a through groove is disposed on the casing (145) , the heat sink (142) is disposed on one side of the casing (145), and is disposed opposite to the through groove, the plurality of heat conduction components (143) pass through the through groove, and portions that are of the plurality of heat conduction components (143) and that extend out of the through groove are connected to the heat sink (142).

7. The heat dissipation apparatus (140) according to any one of claims 1 to 6, wherein the heat sink (142) is a cold plate.

8. The heat dissipation apparatus (140) according to any one of claims 1 to 7, wherein the heat sink (142) is provided with a receiving chamber (142d) and a plurality of insertion ports (142a), a cooling medium is accommodated in the receiving chamber (142d), the plurality of insertion ports (142a) are in communication with the receiving chamber (142d), and one end of each heat conduction component (143) is inserted into one of the insertion ports (142a), extends into the receiving chamber (142d), and is immersed in the cooling medium.

9. An electronic device (100), comprising at least one hard disk (120) and the heat dissipation apparatus (140) according to any one of claims 1 to 8, wherein each hard disk (120) is plugged into one of the plug interfaces (144).

10. The electronic device (100) according to claim 9, wherein the electronic device (100) further comprises a hard disk backplane (130), and the hard disk backplane (130) is located on a side that is of the heat sink (142) and that faces the plurality of heat conduction components (143), and is electrically connected to the at least one hard disk (120).

11. The electronic device (100) according to claim 10, , wherein avoidance space is disposed on the hard disk backplane (130), the avoidance space penetrates the hard disk backplane (130) in a thickness direction of the hard disk backplane (130), and the plurality of heat conduction components (143) pass through the avoidance space.

## Patentansprüche

1. Wärmeableitungseinrichtung (140), umfassend einen Kühlkörper (142) und eine Vielzahl von Wärmeleitungsbauteilen (143), wobei die Vielzahl von Wärmeleitungsbauteilen (143) alle mit dem Kühlkörper (142) verbunden sind, die Vielzahl von Wärmeleitungsbauteilen (143) in Intervallen eingerichtet ist, eine Steckschnittstelle (144) zwischen zwei benachbarten Wärmeleitungsbauteilen (143) ausgebildet ist und die Steckschnittstelle (144) zum Einstecken einer Festplatte (120) verwendet wird;
wobei die Festplatte (120) eine erste Kontaktoberfläche (121) und eine zweite Kontaktoberfläche (122) umfasst, die einander gegenüberliegend angeordnet sind, und die erste Kontaktoberfläche (121) und die zweite Kontaktoberfläche (122) jeweils mit zwei benachbarten Wärmeleitungsbauteilen (143) in Kontakt sind; wobei die Wärmeableitungseinrichtung **dadurch gekennzeichnet ist, dass**:
das Wärmeleitungsbauteil (143) einen Körper (10) und mindestens ein Wärmeleitungselement (20) umfasst, und ein Material des Körpers (10) ein wärmeleitendes Material ist und der Körper (10) eine dritte Kontaktoberfläche (101) und eine vierte Kontaktoberfläche (102), die einander gegenüberliegend angeordnet sind, umfasst, wobei sich das Wärmeleitungselement (20) auf mindestens einer der dritten Kontaktoberfläche (101) und der vierten Kontaktoberfläche (102) befindet und das Wärmeleitungselement (20) mit dem Kühlkörper (142) verbunden ist;
oder das Wärmeleitungsbauteil (143) einen Körper (10) und mindestens ein Wärmeleitungselement (20) umfasst und ein Material des Körpers (10) kein wärmeleitendes Material ist und der Körper (10) eine dritte Kontaktoberfläche (101) und eine vierte Kontaktoberfläche (102), die einander gegenüberliegend angeordnet sind, umfasst, sich das Wärmeleitungselement (20) auf mindestens einer der dritten Kontaktoberfläche (101) und der vierten Kontaktoberfläche (102) befindet, die der Festplatte (120) zugewandt ist, und das Wärmeleitungselement (20) mit dem Kühlkörper (142) verbunden ist.

2. Wärmeableitungseinrichtung (140) nach Anspruch 1, wobei das Wärmeleitungselement (20) ein Wärmerohr ist.

3. Wärmeableitungseinrichtung (140) nach Anspruch 1 oder 2, wobei, wenn das Material des Körpers (10) ein wärmeleitendes Material ist, das Wärmeleitungsbauteil (143) ferner mindestens ein Kontaktelement (30) umfasst und sich das Kontaktelement (30) auf mindestens einer der dritten Kontaktoberfläche (101) und der vierten Kontaktoberfläche (102) befindet; und
wenn das Wärmeleitungselement (20) auf einer Kontaktoberfläche, auf der sich das Kontaktelement (30) befindet, existiert, sich das Kontaktelement (30) auf einer Seite, die von dem Wärmeleitungselement (20) ist und die von dem Körper (10) entfernt ist, befindet und mit dem Wärmeleitungselement (20) in Kontakt ist; oder
wenn das Wärmeleitungselement (20) nicht auf der Kontaktoberfläche, auf der sich das Kontaktelement (30) befindet, existiert, das Kontaktelement (30) direkt mit dem Körper (10) in Kontakt ist.

4. Wärmeableitungseinrichtung (140) nach Anspruch 1 oder 3, wobei, wenn das Material des Körpers (10) kein wärmeleitendes Material ist, das Wärmeleitungsbauteil (143) ferner mindestens ein Kontaktelement (30) umfasst, sich das Kontaktelement (30) auf mindestens einer der dritten Kontaktoberfläche (101) und der vierten Kontaktoberfläche (102), auf der das Wärmeleitungselement (20) existiert, befindet und sich das Kontaktelement (30) auf einer Seite des Wärmeleitungselements (20), die von dem Körper (10) entfernt ist, befindet und mit dem Wärmeleitungselement (20) in Kontakt ist.

5. Wärmeableitungseinrichtung (140) nach Anspruch 3 oder 4, wobei das Kontaktelement (30) eine Federplatte ist.

6. Wärmeableitungseinrichtung (140) nach einem der Ansprüche 1 bis 5, wobei die Wärmeableitungseinrichtung (140) ferner ein Gehäuse (145) umfasst, eine Durchgangsnut auf dem Gehäuse (145) angeordnet ist, der Kühlkörper (142) auf einer Seite des Gehäuses (145) angeordnet ist und gegenüber der Durchgangsnut angeordnet ist, die Vielzahl der Wärmeleitungsbauteile (143) durch die Durchgangsnut passiert und Abschnitte, die von der Vielzahl von Wärmeleitungsbauteilen (143) sind und die sich aus der Durchgangsnut heraus erstrecken, mit dem Kühlkörper (142) verbunden sind.

7. Wärmeableitungseinrichtung (140) nach einem der Ansprüche 1 bis 6, wobei der Kühlkörper (142) eine Kühlplatte ist.

8. Wärmeableitungseinrichtung (140) nach einem der Ansprüche 1 bis 7, wobei der Kühlkörper (142) mit einer Aufnahmekammer (142d) und einer Vielzahl von Einführungsöffnungen (142a) bereitgestellt ist, ein Kühlmedium in der Aufnahmekammer (142d) untergebracht ist, die Vielzahl von Einführungsöffnungen (142a) mit der Aufnahmekammer (142d) in Kommunikation ist und ein Ende jedes Wärmeleitungsbauteils (143) in eine der Einführungsöffnungen (142a) eingeführt ist, sich in die Aufnahmekammer (142d) hinein erstreckt und in das Kühlmedium eintaucht.

9. Elektronische Vorrichtung (100), umfassend mindestens eine Festplatte (120) und die Wärmeableitungseinrichtung (140) nach einem der Ansprüche 1 bis 8, wobei jede Festplatte (120) in eine der Steckschnittstellen (144) eingesteckt ist.

10. Elektronische Vorrichtung (100) nach Anspruch 9, wobei die elektronische Vorrichtung (100) ferner eine Festplattenrückwand (130) umfasst und sich die Festplattenrückwand (130) auf einer Seite, die von dem Kühlkörper (142) ist und die der Vielzahl von Wärmeleitungsbauteilen (143) zugewandt ist, befindet und elektrisch mit der mindestens einen Festplatte (120) verbunden ist.

11. Elektronische Vorrichtung (100) nach Anspruch 10, wobei ein Auslassraum auf der Festplattenrückwand (130) angeordnet ist, der Auslassraum die Festplattenrückwand (130) in einer Dickenrichtung der Festplattenrückwand (130) durchdringt und die Vielzahl der Wärmeleitungsbauteile (143) durch den Auslassraum passieren.

## Revendications

1. Appareil de dissipation de chaleur (140), comprenant un dissipateur thermique (142) et une pluralité de composants de conduction thermique (143), dans lequel la pluralité de composants de conduction thermique (143) sont tous reliés au dissipateur thermique (142), la pluralité de composants de conduction thermique (143) sont disposés à intervalles réguliers, une interface de connexion (144) est formée entre deux composants de conduction thermique (143) adjacents, et l'interface de connexion (144) est utilisée pour le branchement d'un disque dur (120) ;
dans lequel le disque dur (120) comprend une première surface de contact (121) et une deuxième surface de contact (122) disposées face à face, et la première surface de contact (121) et la deuxième surface de contact (122) sont respectivement en contact avec deux composants de conduction thermique (143) adjacents ; dans lequel l'appareil de dissipation de chaleur est **caractérisé en ce que** :
le composant de conduction thermique (143) comprend un corps (10) et au moins un élément de conduction thermique (20), et un matériau du corps (10) est un matériau conducteur de chaleur, et le corps (10) comprend une troisième surface de contact (101) et une quatrième surface de contact (102) disposées face à face, l'élément de conduction thermique (20) est situé sur au moins l'une de la troisième surface de contact (101) et de la quatrième surface de contact (102), et l'élément de conduction thermique (20) est relié au dissipateur thermique (142) ; ou le composant de conduction thermique (143) comprend un corps (10) et au moins un élément de conduction thermique (20), et un matériau du corps (10) n'est pas un matériau conducteur de chaleur, et le corps (10) comprend une troisième surface de contact (101) et une quatrième surface de contact (102) disposées face à face, l'élément de conduction thermique (20) est situé sur au moins l'une de la troisième surface de contact (101) et de la quatrième surface de contact (102) qui fait face au disque dur (120), et l'élément de conduction thermique (20) est relié au dissipateur thermique (142).

2. Appareil de dissipation de chaleur (140) selon la revendication 1, dans lequel l'élément de conduction thermique (20) est un caloduc.

3. Appareil de dissipation de chaleur (140) selon la revendication 1 ou 2, dans lequel, lorsque le matériau du corps (10) est un matériau conducteur de chaleur, le composant de conduction thermique (143) comprend en outre au moins un élément de contact (30), et l'élément de contact (30) est situé sur au moins l'une de la troisième surface de contact (101) et de la quatrième surface de contact (102) ; et
lorsque l'élément de conduction thermique (20) existe sur une surface de contact sur laquelle est situé l'élément de contact (30), l'élément de contact (30) est situé sur un côté de l'élément de conduction thermique (20) et qui est éloigné du corps (10), et est en contact avec l'élément de conduction thermique (20) ; ou
lorsque l'élément de conduction thermique (20) n'existe pas sur la surface de contact sur laquelle se trouve l'élément de contact (30), l'élément de contact (30) est directement en contact avec le corps (10).

4. Appareil de dissipation de chaleur (140) selon la revendication 1 ou 3, dans lequel, lorsque le matériau du corps (10) n'est pas un matériau conducteur de chaleur, le composant de conduction thermique (143) comprend en outre au moins un élément de contact (30), l'élément de contact (30) est situé sur au moins l'une de la troisième surface de contact (101) et de la quatrième surface de contact (102) sur laquelle l'élément de conduction thermique (20) existe, et l'élément de contact (30) est situé sur un côté de l'élément de conduction thermique (20) et qui est éloigné du corps (10), et est en contact avec l'élément de conduction thermique (20).

5. Appareil de dissipation de chaleur (140) selon la revendication 3 ou 4, dans lequel l'élément de contact (30) est une plaque à ressort.

6. Appareil de dissipation de chaleur (140) selon l'une quelconque des revendications 1 à 5, dans lequel l'appareil de dissipation de chaleur (140) comprend en outre un boîtier (145), une rainure traversante est disposée sur le boîtier (145), le dissipateur thermique (142) est disposé sur un côté du boîtier (145), et est disposé à l'opposé de la rainure traversante, la pluralité de composants de conduction thermique (143) traversent la rainure traversante, et les parties qui sont de la pluralité de composants de conduction thermique (143) et qui s'étendent hors de la rainure traversante sont reliées au dissipateur thermique (142).

7. Appareil de dissipation de chaleur (140) selon l'une quelconque des revendications 1 à 6, dans lequel le dissipateur thermique (142) est une plaque froide.

8. Appareil de dissipation de chaleur (140) selon l'une quelconque des revendications 1 à 7, dans lequel le dissipateur thermique (142) est muni d'une chambre de réception (142d) et d'une pluralité d'orifices d'insertion (142a), un milieu de refroidissement est logé dans la chambre de réception (142d), la pluralité d'orifices d'insertion (142a) communiquent avec la chambre de réception (142d), et une extrémité de chaque composant de conduction thermique (143) est insérée dans l'un des orifices d'insertion (142a), s'étend dans la chambre de réception (142d) et est immergée dans le milieu de refroidissement.

9. Dispositif électronique (100), comprenant au moins un disque dur (120) et l'appareil de dissipation de chaleur (140) selon l'une quelconque des revendications 1 à 8, dans lequel chaque disque dur (120) est branché sur l'une des interfaces de connexion (144).

10. Dispositif électronique (100) selon la revendication 9, dans lequel le dispositif électronique (100) comprend en outre un fond de panier de disque dur (130), et le fond de panier de disque dur (130) est situé sur un côté du dissipateur thermique (142) et qui fait face à la pluralité de composants de conduction thermique (143), et est électriquement connecté à l'au moins un disque dur (120).

11. Dispositif électronique (100) selon la revendication 10, dans lequel un espace d'évitement est disposé sur le fond de panier de disque dur (130), l'espace d'évitement pénètre le fond de panier de disque dur (130) dans un sens de l'épaisseur du fond de panier de disque dur (130), et la pluralité de composants de conduction thermique (143) passent à travers l'espace d'évitement.
